# EUROPEAN PATENT APPLICATION

(11) **EP 2 453 476 A1**
(43) Date of publication of application: **16.05.2012**
(21) Application number: 10191081.8
(22) Date of filing: 12.11.2010
(51) Int. Cl.: H01L 23/495

(54) **Semiconductor device packaging method and semiconductor device package**

(71) Applicant: NXP B.V., 5656 AG Eindhoven (NL)
(72) Inventor: Groenhuis, Roelf Anco Jacob, Redhill, Surrey RH1 1DL (GB); Walczyk, Sven, Redhill, Surrey RH1 1DL (GB); Dijkstra, Paul, Redhill, Surrey RH1 1DL (GB); de Bruin, Emiel, Redhill, Surrey RH1 1DL (GB)
(74) Representative: Burton, Nick

(57) **Abstract**

Disclosed is a discrete semiconductor device package (100) comprising a leadframe portion (10) comprising a recess (14) having a depth substantially equal to the thickness of the discrete semiconductor device (20), wherein a raised portion of the leadframe portion adjacent to said recess defines a first contact area (12); a discrete semiconductor device (20) in said recess, wherein the exposed surface (22) of the discrete semiconductor device defines a second contact area; a protective layer (30) covering the leadframe portion and the a discrete semiconductor device but not the first contact area and the second contact area; and respective plating layers (40) covering the first contact area and the second contact area. A method of manufacturing such a package and a carrier comprising such a package are also disclosed.

## Description

### FIELD OF THE INVENTION

The present invention relates to a method of packaging a discrete semiconductor device such as a diode.

The present invention further relates to a discrete semiconductor device obtained by such a method.

### BACKGROUND OF THE INVENTION

Discrete semiconductor devices such as diodes are typically provided in a package when marketed. The package protects the discrete semiconductor device from accidental damage and provides the contacts for integrating the discrete semiconductor device in a larger electronic device, e.g. by mounting the discrete semiconductor device on a printer circuit board (PCB). In the known packaging approaches, the package contacts are typically fan-outs of the contacts of the discrete semiconductor device, i.e. have a larger area, as manufacturing approaches to reproduce the small dimensions of a discrete semiconductor device at the package level in a straightforward and cost-effective manner are currently unavailable.

As a consequence of the ongoing miniaturization of semiconductor devices including discrete semiconductor devices, the corresponding package sizes have to be miniaturized as well. This, however, is not trivial, as the fan-out of the package contacts poses a lower limit of the dimensions of the package. For instance, for diode packages, it is difficult to miniaturize the package beyond dimensions of 0.6 mm x 0.3 mm x 0.3 mm. Such packages are known as 0603 packages. This lower limit is largely dictated by the dimensions of the fan-out package contacts. Hence, there exists a need for a packaging method that facilitates further miniaturization of discrete semiconductor device packages and in particular diode packages in a relatively straightforward and therefore cost-effective manner.

### SUMMARY OF THE INVENTION

The present invention seeks to provide a method of manufacturing a discrete semiconductor device package that facilitates the manufacture of packages smaller than 0603 packages.

The present invention further seeks to provide a discrete semiconductor device package obtained by such a method.

In accordance with an aspect of the present invention, there is provided a method of manufacturing a discrete semiconductor device package, the method comprising providing a leadframe; forming a recess in said leadframe, said recess having a depth substantially equal to the thickness of the discrete semiconductor device, wherein a raised portion of the leadframe adjacent to said recess defines a first contact area; placing the discrete semiconductor device with its active side face down in said recess, wherein the exposed surface of the discrete semiconductor device defines a second contact area; molding the resultant product in a protective layer, leaving the surface including the first contact area and the second contact area exposed; and covering the exposed first contact area and the second contact area with respective plating layers.

By ensuring that the depth of the recess closely resembles the thickness of the discrete semiconductor device to be placed therein, a very compact package can be manufactured having reduced dimensions. This is further facilitated by the partial molding of the package and the provision of a solderable plating layer on the exposed contact areas, such that these contact areas can be used to attach the package to a suitable carrier without requiring fan-out of the contact areas, thus further reducing the form factor of the package.

The recess may be formed by stamping or etching, if necessary combined with a flattening step to ensure that the recess has the appropriate depth.

The discrete semiconductor device has its active side placed face down, i.e. facing the recess surface. This facilitates extending a contact between the second contact area and a carrier over the side of the discrete semiconductor package, which would not be possible in case the active side would be facing upwards, as such an arrangement would likely result in an electrical short in case of the contact extending over the side of the package.

In an embodiment, the step of placing the discrete semiconductor device in said recess comprises interconnecting the placing the discrete semiconductor device to the leadframe using a conductive fixating agent. The conductive fixating agent may for instance be a conductive adhesive paste or conductive wafer back coating. Such a fixation technique can be realized using a very thin layer of the fixating agent, thus further aiding in limiting the overall dimensions of the package.

In another embodiment, said placing step comprises placing the discrete semiconductor device in said recess with its active side down.

Advantageously, the step of etching said recess comprises etching a plurality of recesses in said leadframe, wherein raised portions of the leadframe adjacent to each of said recesses define respective first contact areas; and the step of placing the discrete semiconductor device in said recess comprises placing a discrete semiconductor device in each of said recesses, the exposed surfaces of the discrete semiconductor devices defining respective second contact areas; the method further comprising separating the leadframe into individualized discrete semiconductor device packages. Hence, a plurality of packages may be formed from a single leadframe.

Preferably, the difference between the thickness of the discrete semiconductor device and the depth of the recess is less than 0.1 mm. This ensures that the first and second contact areas can be effectively mounted onto a flat surface. In addition or alternatively, the molding step may be used to negate any difference between the depth of the recess and the thickness of the discrete semiconductor device.

In another embodiment, the step of molding the resultant product in a protective layer comprises covering the first contact area and the second contact area with a protective foil. This ensures that the contact areas do not become contaminated with molding material. In the molding step, the backside of the leadframe, i.e. the side that received the active side of the discrete semiconductor device is protected from being covered by the molding material, for instance by a standard lead frame tape.

In accordance with another aspect of the present invention, there is provided a discrete semiconductor device package comprising a leadframe portion comprising a recess having a depth substantially equal to the thickness of the discrete semiconductor device, wherein a raised portion of the leadframe adjacent to said recess defines a first contact area; a discrete semiconductor device in said recess, wherein the exposed surface of the discrete semiconductor device defines a second contact area; a protective layer covering the leadframe portion and the discrete semiconductor device but not the first contact area and the second contact area; and respective plating layers covering the first contact area and the second contact area.

Such a package can be manufactured to smaller dimensions than what is currently possible, thus aiding the further miniaturization of such packages.

In an embodiment, after applying the protective molding compound, the surface opposite the surface including the first contact and the second contact is covered with a protective, electrically insulating layer. The electrically insulating layer may be formed using a lacquer, tape, foil, and so on.

In an embodiment, the respective plating layers each cap a respective end surface of the package. This has the advantage that a solder interconnecting the contact areas to respective carrier contacts may extend vertically onto these plating caps, thereby improving the quality of the contact between the discrete semiconductor device package and the carrier.

According to yet another aspect of the present invention, there is provided a carrier comprising a first carrier contact and a second carrier contact, said carrier further comprising the discrete semiconductor device package according to an embodiment of the present invention, wherein the first carrier contact is conductively connected to the first contact area and the second carrier contact is conductively connected to the second contact area by respective solder portions. Such a carrier may for instance be an electronic device, a printed circuit board, a multi-chip module, and so on.

### BRIEF DESCRIPTION OF THE EMBODIMENTS

Embodiments of the invention are described in more detail and by way of non-limiting examples with reference to the accompanying drawings, wherein
FIG. 1-3 schematically depict various stages of a method according to an embodiment of the present invention;
Fig 4 schematically depict the finalized package according to an embodiment of the present invention;
FIG. 5-11 schematically depict various stages of a method according to another embodiment of the present invention;
FIG. 12-13 schematically depict various stages of a method according to yet another embodiment of the present invention; and
FIG. 14 schematically depicts a carrier including a discrete semiconductor device package according to an embodiment of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

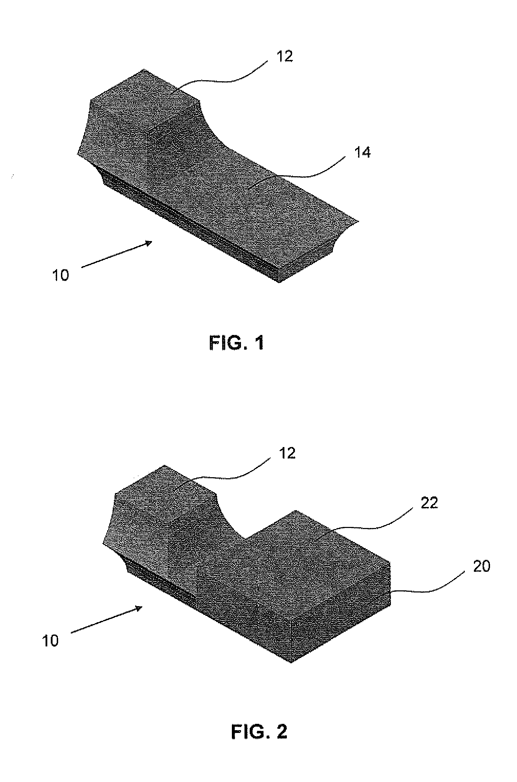

As shown in FIG. 1, a suitable leadframe 10, e.g. a leadless carrier such as a QFN (quad flat no leads) or a MCD leadframe is provided, in which a recess 14 is provided e.g. by stamping or etching with any suitable etch recipe to provide a leadframe 10 in which a first contact portion 12 is defined adjacent to the recess 14. The recess 14 has a depth that is equal or close to the thickness of the discrete semiconductor device to be placed in the recess 14. The desired depth of the recess may for instance be achieved by combination of an etching or stamping step with a subsequent flattening step. In a preferred embodiment, the difference between the thickness of the discrete semiconductor device and the depth of the recess 14 is less than 0.1 mm. Most preferably, the thickness of the discrete semiconductor device is identical to the depth of the recess to the extent that the exposed surface of the discrete semiconductor device lies in the same plane as the surface area of the first contact portion 12.

FIG. 1 depicts a leadframe 10 comprising a single recess 14 and a single contact portion 12 for the sake of clarity. It should however be understood that in a preferred embodiment the leadframe 10 comprises an array of recesses 14 and adjacent contact portions 12 such that a plurality of packages may be formed from a single leadframe 10.

In the next step, the discrete semiconductor device 20 is placed in the recess 14. This is shown in FIG. 2. The discrete semiconductor device 20 has a contact surface 22 defining a second contact area. As previously explained, the contact surface 22 preferably lies in the same plane as the surface of the first contact portion 12. The discrete semiconductor device 20 may be conductively interconnected to the leadframe 10 in any suitable manner. For instance, the conductive interconnection may be formed using conductive adhesive paste or wafer back coating. If the discrete semiconductor device 20 is placed onto the leadframe 10 with its active side down, this implies that the wafer back coating is applied to the top side of the wafer of the discrete semiconductor device 20.

At this stage, it is noted that the discrete semiconductor device 20 may be any suitable semiconductor device. In particular, the discrete semiconductor device 20 may be a discrete diode, although other discrete devices, e.g. transistors, are equally feasible. The wafer material from which the discrete semiconductor device 20 is formed may be any suitable semiconductor material, such as silicon, SiGe and so on.

Preferably, the active area of the discrete semiconductor device 20 including seal ring is kept smaller than 0.2 mm, such that the total package width can be limited to 0.2 mm.

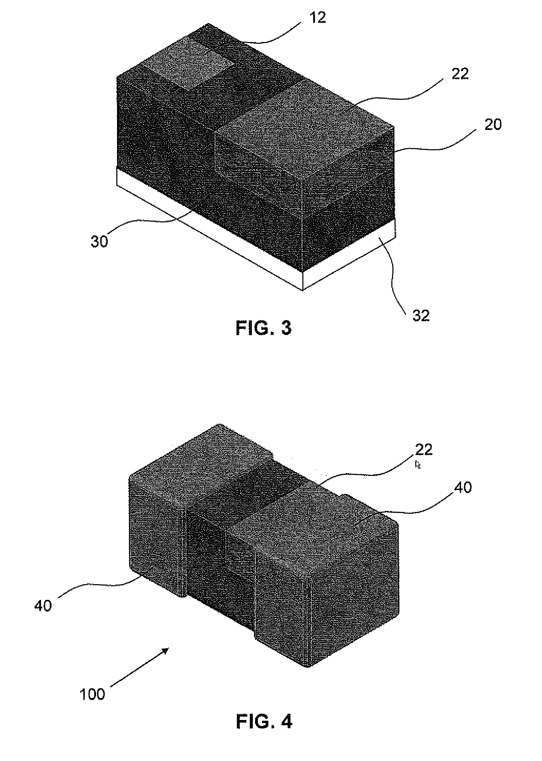

In the next step, as shown in FIG. 3, the resultant structure is molded with a protective resin, which envelopes the leadframe 10 and the discrete semiconductor device 20 placed thereon. However, the first contact surface 12 and the second contact surface 22 are left exposed. This may be achieved in any suitable manner, for instance by covering these contact surfaces with a foil to protect them from being covered by the protective resin. After the molding step, the foil may simply be removed to expose the first contact surface 12 and the second contact surface 22. Any suitable protective resin, such as an epoxy molding compound may be used.

Before separation of the leadframe 10 into individual discrete semiconductor packages, a protective, electrically insulating layer 32 is applied to the back side of the leadframe, as shown in FIG. 3. This electrically insulates the active side of the discrete semiconductor device 20, thereby reducing the risk of an electrical short between a carrier and the active side of the discrete semiconductor device 20 when mounting the package onto said carrier. In particular, the first contact surface 12 and the discrete semiconductor device 20 are connected via the leadframe 10, the first contact surface 12 and the second contact surface 22 are only connected by the function in the IC, e.g. a diode function and the remainder of the IC needs to be insulated from the first contact surface 12, which is the purpose of the electrically insulating layer 32.

At this stage, the leadframe 10 may be separated into the individualized discrete semiconductor packages in any suitable manner, e.g. by dicing, cutting or sawing. This is not explicitly shown. Following the individualization, the contact surfaces 12 and 22 of the separate discrete semiconductor packages are provided with a solderable plating 40 as shown in FIG. 4 to yield the finalized separate discrete semiconductor device package 100. The plating 40 may be applied in any suitable manner, e.g. barrel plating, or alternatively electroless plating may be used.

In FIG. 4, the second contact surface 22 of the discrete semiconductor device 20 is only partially covered by the plating layer 40 by way of non-limiting example only. It should be understood that it is equally feasible to cover the whole contact surface 22 with the plating layer 40. This will be typically determined by the size of the discrete semiconductor device 20.

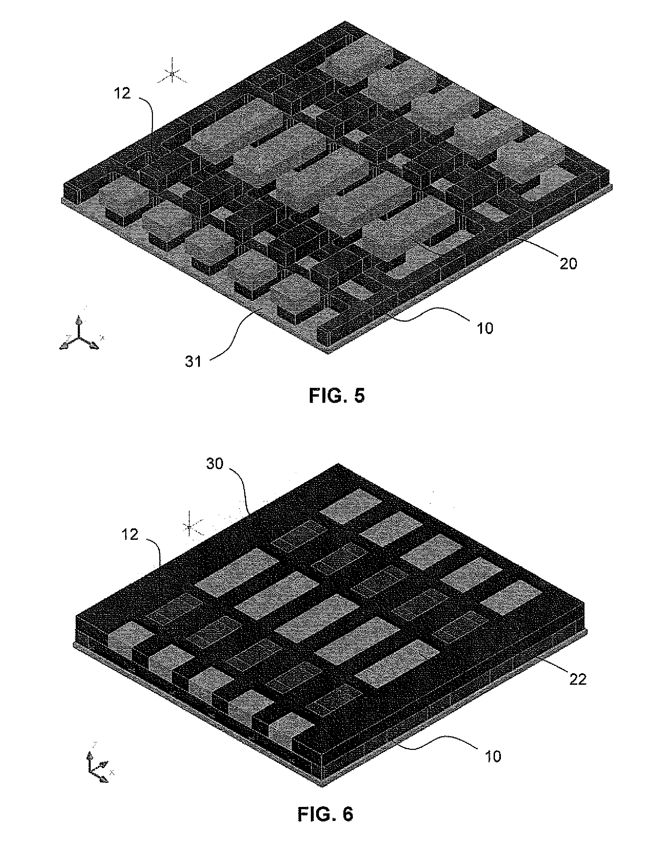

The process steps explained with the aid of FIG. 1-3 may be implemented in a number of suitable ways, non-limiting examples of which will be given with the aid of FIG. 5-12.

FIG. 5 shows the placement of the dies 20 onto a leadframe 10 having raised contact portions 12 as previously explained. The leadframe 10 may comprise a leadframe tape 31 to electrically insulate the bottom of the leadframe. After placement of the dies 20 on the leadframe 10, the resultant structure may be molded with a protective resin 30, such that the first contact surfaces 12 and the second contact surfaces 22 remain exposed. Preferably, the molding step is a foil-assisted molding step in which the first contact surfaces 12 and the second contact surfaces 22 are protected by a foil (not shown) during molding to avoid contamination of these contact surfaces. After the molding step, the lead frame tape 31 may be removed and replaced with an electrically insulating layer 32 as shown in FIG. 3 such as a tape marketed by the Lintec Corporation, Japan to electrically insulate the bottom of the leadframe.

From this point onwards, several variations to the process flow are possible.

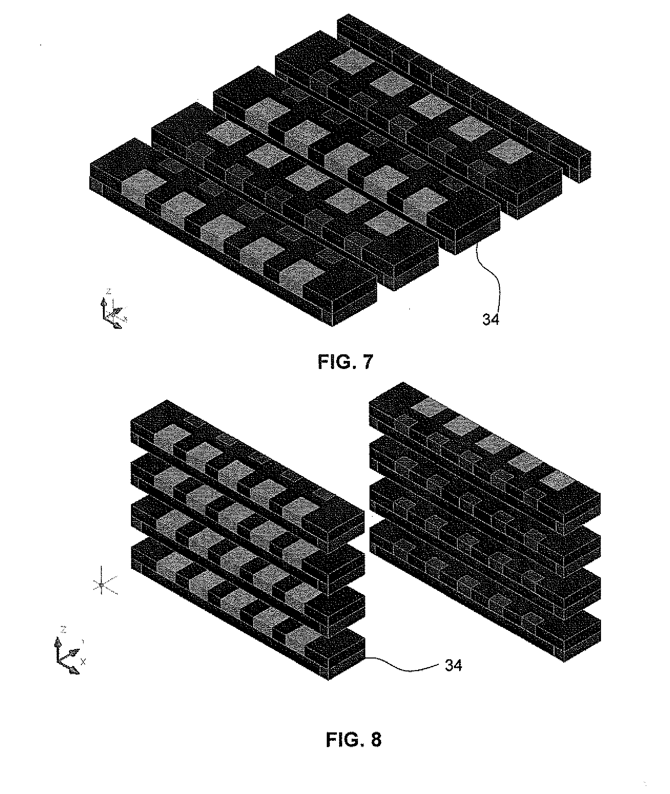

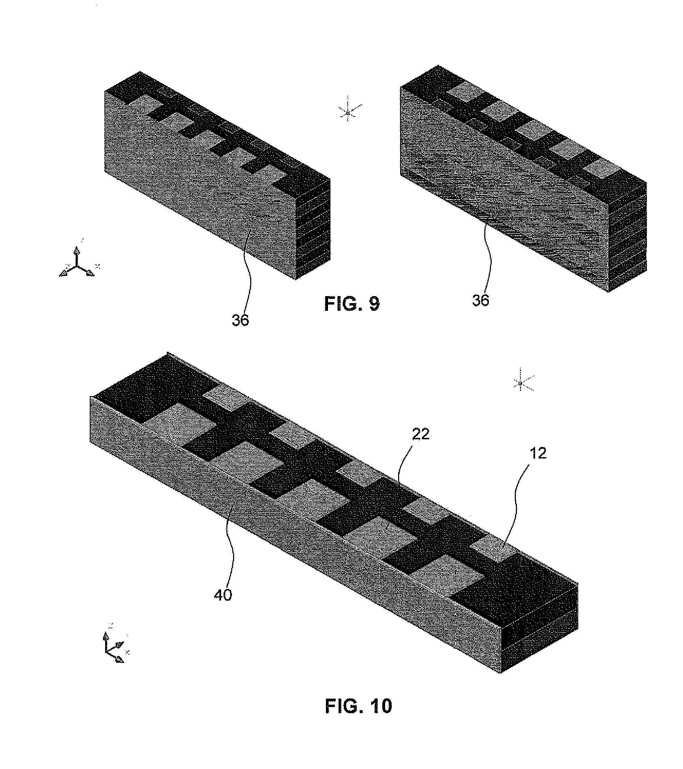

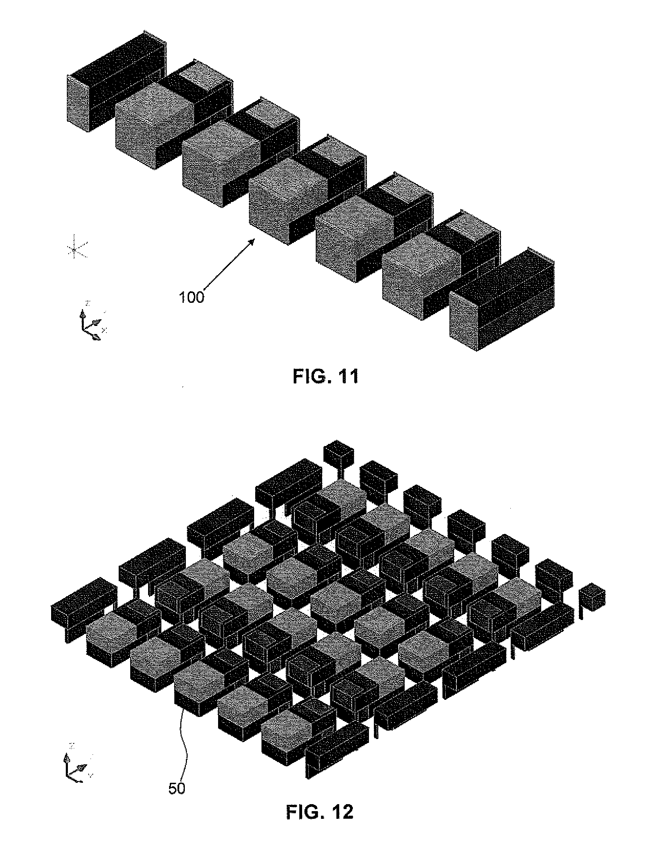

In a first non-limiting example, the leadframe 10 may be separated in strips 34 as shown in FIG. 7. This may be done in any suitable manner, e.g. dicing, sawing, laser cutting and so on. The strips 34 are subsequently stacked as schematically shown in FIG. 8 (it should be understood that the strips 34 are shown separated from each other for clarity purposes; in reality they are stacked in physical contact with each other) , after which a seed layer 36 is sputtered onto the surfaces to be plated as shown in FIG. 9. Any suitable metal may be used for such a seed layer. In an embodiment, prior to the formation of the seed layer, the surfaces to receive the seed layer may be treated with e.g. a plasma etch to increase the adhesion of the seed layer to the surfaces. The process proceeds as shown in FIG. 10 with a contact plating step to form side contacts 40, after which the strips are separated into individual discrete semiconductor device packages 100 as shown in FIG. 11. It should be understood that the contact plating step may also cover the first contact area 12 and the second contact area 22, as for instance is shown in FIG. 10.

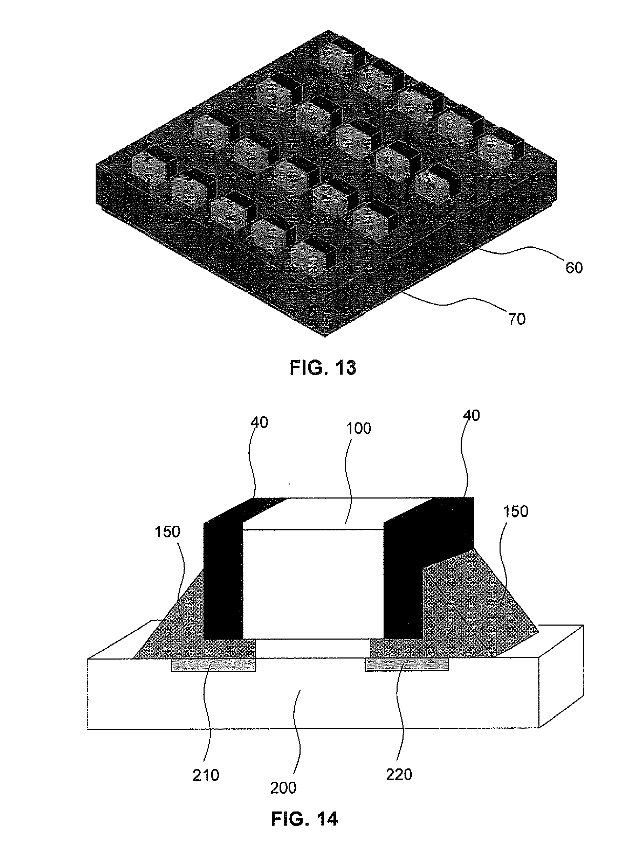

In a second non-limiting example, the process may continue from FIG. 6 as shown in FIG. 12, in which the leadframe 10 and mounted dies 20 are separated into individual components 50 that are subsequently placed in a frame 60, as shown in FIG. 13. The frame 60 may be supported by a support tape 70 to improve the fixation of the individual components 50. After placement in the frame 60, a conductive paste is applied to the surfaces of the individual components 50 to be plated followed by a contact plating step to finalize the discrete semiconductor device packages 100. Both sides of the components 50 may be plated in this manner.

It should be understood that such plating processes are for instance well-known from the production of passive components such as multi-layer chip capacitors and thin film resistors. Suitable plating materials include tin, silver, metal alloys and layer stacks such as a niAu finish, NiPdAu and so on.

Upon returning to FIG. 4, it is noted that FIG. 4 depicts a preferred embodiment of the discrete semiconductor device package 100, in which the plating layers 40 cap the end portions of the package. This will be explained in more detail with the aid of FIG. 14. However, it should be understood that it is not essential for the plating layers 40 to completely cover the end portions of the package 100. Alternative embodiments, such as an embodiment in which the plating layers 40 only cover the respective surfaces 12 and 22 are equally feasible.

It is pointed out that with the above described method it is feasible to produce a discrete semiconductor device package 100 having dimensions not exceeding 0.4x0.2x0.2 mm (length x width x height). However, it should be understood that smaller dimension and larger dimension packages can also be achieved without departing from the present invention.

Traditionally, discrete semiconductor device packages are mounted on a carrier such as a PCB in a top/bottom contact orientation, with the bottom contact directly bonded to the carrier, and with the top contact being a wire bonding contact for wire bonding the top contact to the carrier. The provision of the wire bonding contact requires a minimum area which has prohibited the reduction of the package size beyond certain dimensions.

In contrast, the replacement of a wire bonding contact with the conductive adhesive layer between the discrete semiconductor device 20 and the leadframe 10 facilitates the sideways mounting of such packages on a carrier 200 such as a PCB as shown in FIG. 14, with the solderable plating layers 40 providing the contacts from the package 100 to the outside world. Carrier 200 has a first contact 210 and a second contact 220, to which the discrete semiconductor device package 100 is soldered using soldering 150. The provision of the plating layers 40 as caps on the end portions of the discrete semiconductor device package 100 enables the soldering 150 to extend vertically from the respective contacts 210 and 220. The sideways mounting of the discrete semiconductor device package 100 allows the package to be used with PCBs that have been designed to receive larger form factor components, e.g. 0603 diode packages.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of manufacturing a discrete semiconductor device package (100), comprising:
providing a leadframe (10);
forming a recess (14) in said leadframe, said recess having a depth substantially equal to the thickness of the discrete semiconductor device, wherein a raised portion of the leadframe adjacent to said recess defines a first contact area (12);
placing the discrete semiconductor device (20) with its active area face down in said recess, wherein the exposed surface (22) of the discrete semiconductor device defines a second contact area;
molding the resultant product in a protective layer (30), leaving the surface including the first contact area and the second contact area exposed;
covering the surface opposite the surface comprising the first contact area and the second contact area with a protective electrically insulating layer;
and
covering the exposed first contact area and the second contact area with respective plating layers (40).

2. The method of claim 1, wherein the step of placing the discrete semiconductor device (20) in said recess (14) comprises interconnecting the placing the discrete semiconductor device to the leadframe (10) using a conductive fixating agent.

3. The method of claim 2, wherein the conductive fixating agent is a conductive adhesive paste or conductive wafer back coating.

4. The method of any of claims 1-3, wherein the step of forming the recess is performed by etching or stamping.

5. The method of any of claims 1-4, wherein:
the step of etching said recess (14) comprises etching a plurality of recesses in said leadframe (10), wherein raised portions of the leadframe adjacent to each of said recesses define respective first contact areas (12); and
the step of placing the discrete semiconductor device (20) in said recess (14) comprises placing a discrete semiconductor device in each of said recesses, the exposed surfaces (22) of the discrete semiconductor devices defining respective second contact areas;
the method further comprising separating the leadframe (10) into individual discrete semiconductor device packages.

6. The method of any of claims 1-5, wherein the difference between the thickness of the discrete semiconductor device (20) and the depth of the recess (14) is less than 0.1 mm.

7. The method of any of claims 1-6, wherein the step of molding the resultant product in a protective layer (30) comprises covering the first contact area (12) and the second contact area (22) with a protective foil to prevent molding material forming over said contact areas.

8. The method of any of claims 1-7, wherein the leadframe (10) is a QFN (Quad Flat No leads) leadframe.

9. A discrete semiconductor device package (100) comprising:
a leadframe portion (10) comprising a recess (14) having a depth substantially equal to the thickness of the discrete semiconductor device (20), wherein a raised portion of the leadframe portion adjacent to said recess defines a first contact area (12);
a discrete semiconductor device (20) in said recess, wherein the exposed surface (22) of the discrete semiconductor device defines a second contact area;
a protective layer (30) covering the leadframe portion and the a discrete semiconductor device but not the first contact area and the second contact area;
a further protective insulating layer on the surface opposite the surface comprising the the first contact area and the second contact area; and
respective plating layers (40) covering the first contact area and the second contact area.

10. The discrete semiconductor device package (100) of claim 9, wherein the discrete semiconductor device (20) is interconnected to the leadframe portion (10) by a conductive fixating agent.

11. The discrete semiconductor device package (100) of claim 10, wherein the conductive fixating agent is a conductive adhesive paste, a conductive wafer back coating or a soldered interconnect.

12. The discrete semiconductor device package (100) of any of claims 9-11, wherein the discrete semiconductor device (20) is placed in said recess (14) with its active side down.

13. The discrete semiconductor device package (100) of any of claims 9-12, wherein the difference between the thickness of the discrete semiconductor device (20) and the depth of the recess (14) is less than 0.1 mm.

14. The discrete semiconductor device package (100) of any of claims 9-13, wherein the respective plating layers (40) each cap a respective end surface of the package.

15. A carrier (200) comprising a first carrier contact (210) and a second carrier contact (220), said carrier further comprising the discrete semiconductor device package (100) of any of claims 9-14, wherein the first carrier contact is conductively connected to the first contact area and the second carrier contact is conductively connected to the second contact area by respective solder portions (150).
